# EUROPEAN PATENT SPECIFICATION

(11) **EP 4 030 145 B1**
(45) Date of publication and mention of the grant of the patent: **17.07.2024**
(21) Application number: 21151706.5
(22) Date of filing: 14.01.2021
(51) Int. Cl.: G01D 5/14, G01D 5/245, G01R 33/09

(54) **POSITION SENSING MECHANISM**
POSITIONSERFASSUNGSVORRICHTUNG
MÉCANISME DE DÉTECTION DE POSITION

(43) Date of publication of application: 20.07.2022
(73) Proprietor: Hiwin Mikrosystem Corp., Taichung City 40852 (TW)
(72) Inventor: LAI, Chih-Huang, 40852 Taichung City (TW); LEE, Chia-Chang, 40852 Taichung City (TW); XU, Zhi-Hao, 40852 Taichung City (TW); HSIAO, Heng-Sheng, 40852 Taichung City (TW)
(74) Representative: Lang, Christian

(56) References cited:
- EP-A1- 2 955 487
- EP-A1- 3 413 311
- EP-A2- 2 589 975
- DE-A1- 102018 211 216
- US-A1- 2010 296 202
- US-A1- 2013 063 841
- US-A1- 2020 182 947

## Description

### BACKGROUND OF THE INVENTION

### Field of Invention

The invention relates to sensing technology, and more particularly to a position sensing mechanism that uses a tunneling magneto-resistor for sensing positions.

### Related Art

The sensing technology for position analysis by sensing changes of a specific signal such as magnetism or light in an encoding element under changes in position is a widely used technical means in the prior art. Specifically, for example, in the previous patent US6100681A, it uses two sets of Hall sensor chips with a position difference of 90 degrees relative to each other to sense position changes along a moving direction. Or, as disclosed in the patent publication US20090102461A, in the technology provided by the encoding element that uses magnetism as the signal source, the two magnetic tracks provided are set to the binary system and the decimal system, and then a plurality of discrete Hall sensing elements are used to sense the changes in the magnetic field of each of the magnetic tracks respectively, and the changes in the magnetic fields are analyzed to obtain position information. In such a technical means of using the Hall elements as the magnetic sensing elements, although it is a common technique in the position sensing technology, due to the high power consumption and low sensitivity of the Hall element itself, it still has its limitations as a position sensing element, especially in applications that require low power consumption and high sensing sensitivity, and therefore the Hall sensing element has been unable to meet the requirements of the industry.

Further, as disclosed in the patent US10480963 shown in FIG. 1 in the prior art, although it also uses the Hall sensor 1 as a sensing element for the absolute column magnetic track 2, and in the sensing of the incremental column magnetic track 3, magneto-resistive element such as the spin-valve tunneling magneto-resistive (SV TMR) element 4 or the anisotropic magneto-resistive (AMR) element with relatively low-power and high-sensitivity is used as a sensing element to obtain better sensing sensitivity; however, the spin-valve tunneling magneto-resistive element 4 or the anisotropic magneto-resistive element obtains position analysis information by sensing changes of a magnetic field angle caused by the movement of the magnetic track, and in order to accurately sense changes of the magnetic field angle in the incremental column magnetic track 3, a film surface of the spin-valve tunneling magneto-resistive element 4 or the anisotropic magneto-resistance element must be located on the x-z plane, resulting in the absolute column magnetic track sensing element on the x-y plane, that is, the Hall sensor 1, being in a spatial state of locating on a different plane, which leads to the need of manufacturing each of sensing components of the absolute column and the incremental column individually as parts, and then separately aligning the components precisely before assembling them on a base plate (not shown in the figure); as a result, the assembly procedures and costs are not only increased, but the accuracy of alignment also affects the accuracy of position determination, and therefore it is difficult to effectively improve the yield of the product.

Patent application publication DE 10 2018 211 216 A1 discloses a position sensing mechanism having the features of the preambles of claims 1 and 2. A further position sensing mechanism is known from patent application publication US 201010296202 A1.

### SUMMARY OF THE INVENTION

Therefore, a main object of the invention is to provide a position sensing mechanism, which uses tunneling magneto-resistance for sensing of positions, and sensing elements are directly formed on a base plate to obtain an integrated sensor with a plurality of sensing elements, thereby avoiding assembly procedures of assembling the sensing elements on the base plate as independent discrete parts, and ensuring that ab accuracy of position sensing is not affected by poor assembly procedures.

In order to achieve the above object, the invention provides position sensing mechanisms having the features of claim 1. The position sensing mechanism provided by the invention comprises an encoding element as a sensing signal source, a reading element for sensing signals of the signal source, and a processing unit for receiving and analyzing sensing signals output by the reading element, the position sensing mechanism has a main technical feature lying in a magneto-resistive unit in the reading element for sensing signals of the signal source being a tunneling magneto-resistor (TMR), and two layers of magnetic moments of a reference layer and a free layer of the tunneling magneto-resistor being perpendicular to each other, and in the reference layer and the free layer with the magnetic moments being perpendicular to each other, the magnetic moment of one of the layers is parallel to a film surface, and the magnetic moment of the other layer is perpendicular to the film surface.

Wherein the magnetic moment perpendicular to the film surface can be the reference layer or the free layer.

### BRIEF DESCRIPTION OF THE DRAWINGS

FIG. 1 is a perspective view of a prior art;
FIG. 2 is a perspective view of a preferred embodiment of the invention;
FIG. 3 is a plan view of a tunneling magneto-resistor as a magneto-resistive unit in a preferred embodiment of the invention;
FIG. 4 is a diagram of relationship between resistance and magnetic field in a preferred embodiment of the invention;
FIG. 5 is a waveform diagram of a sensing signal for an incremental column in a preferred embodiment of the invention; and
FIG. 6 is a waveform diagram of a sensing signal for an absolute column in a preferred embodiment of the invention.

### DETAILED DESCRIPTION OF THE INVENTION

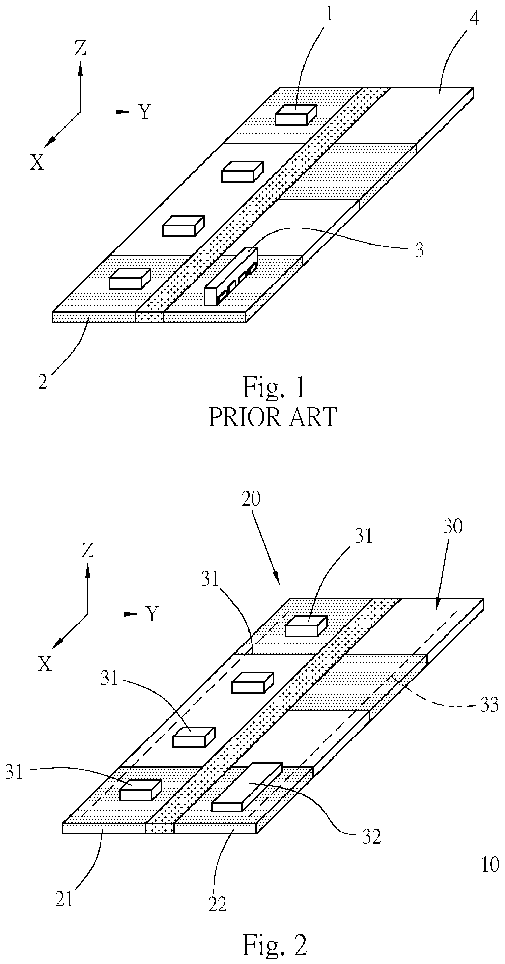

First of all, please refer to FIG. 2, a position sensing mechanism 10 provided in a preferred embodiment of the invention mainly comprises an encoding element 20, a reading element 30, and a processing unit (not shown in the figure).

The encoding element 20 is a conventional magnetic ruler technology that uses magnetic field as a signal source, the encoding element 20 structurally comprises an absolute column magnetic track 21 and an incremental column magnetic track 22, the absolute column magnetic track 21 and the incremental column magnetic track 22 extend side by side with each other along a virtual moving axis, and magnetic poles are changed on an x-y plane shown in FIG. 2 according to a preset encoding method. Generally, the moving axis is usually linear and consistent with a longitudinal direction of the magnetic ruler, however, regarding the magnetic ruler technology that comprises the absolute column magnetic track 21 and the incremental column magnetic track 22, since it is the technical content that is known to those having ordinary skill in the art to which the invention pertains prior to the application of the invention, the specific magnetic poles arrangement, manufacturing process, or related technology will not be described here.

The reading element 30 comprises first magneto-resistive units 31 and a second magneto-resistive unit 32, a quantity of each of the magneto-resistive units can be set according to actual requirements, and the quantity does not hinder the achievement of the technical features of the invention, so the numerical value of the quantity will not be further explained. As for the reading element 30 as a whole, the reading element 30 is separated from the encoding element 20 and adjacent to one side of the encoding element 20, and a projection range of the reading element 30 toward the encoding element 20 is capable of covering the absolute column magnetic track 21 and the incremental column magnetic track 22, so that between the reading element 30 and the encoding element 20, whether the reading element 30 is moved relative to the encoding element 20 or the encoding element 20 is moved relative to the reading element 30, when both of the reading element 30 and the encoding element 20 produce relative displacement on the moving axis, changes of magnetic fields of the incremental column magnetic track 22 and the absolute column magnetic track 21 can be sensed by the reading element 30. Specifically, the first magneto-resistive units 31 correspond to the absolute column magnetic track 21 to sense changes of magnetic field of the absolute column magnetic track 21 in the above-mentioned relative displacement state. The second magneto-resistive unit 32 corresponds to the incremental column magnetic track 22 to sense changes of magnetic field of the incremental column magnetic track 22 in the above-mentioned relative displacement state. Thereby, after the absolute column magnetic track 21 and the incremental column magnetic track 22 are sensed by the first magneto-resistive units 31 and the second magneto-resistive unit 32, sensing signals are output, and the processing unit is capable of analyzing relative positions of the reading element 30 and the encoding element 20 based on the sensing signals in order to obtain information of moved positions to be provided for the control of driving components such as linear motor or rotary motor.

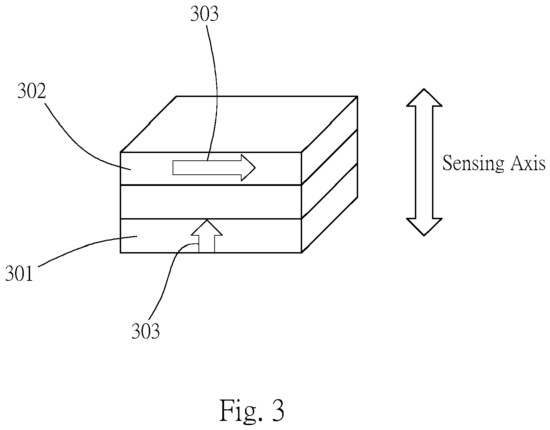

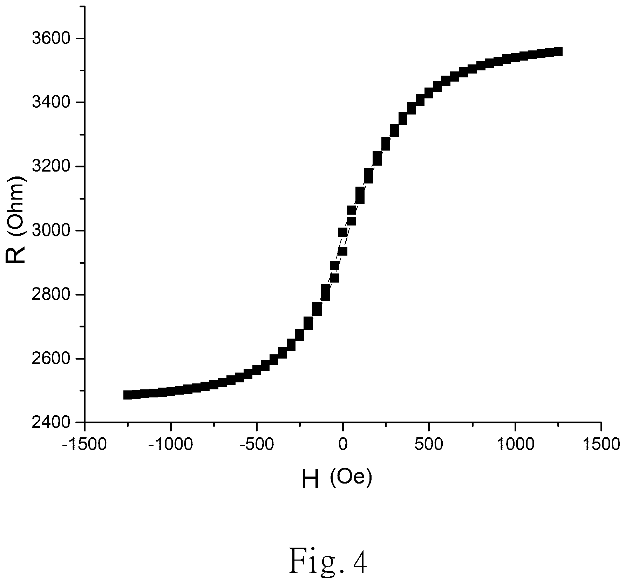

It is necessary to further explain that the first magneto-resistive units 31 and the second magneto-resistive unit 32 are different from the conventional technology employing different sensing elements for the absolute and incremental columns, but instead both the first magneto-resistive units 31 and the second magneto-resistive unit 32 have the same technical structure, and as disclosed in this embodiment, both the first magneto-resistive units 31 and the second magneto-resistive unit 32 have a tunneling magneto-resistive (TMR) structure as shown in FIG. 3. However, the first magneto-resistive unit 31 can be a tunneling magneto-resistor with a single magnetic tunneling junction (single MTJ), and the second magneto-resistive unit 32 is a bridge tunneling magneto-resistor (bridge TMR), two layers of magnetic moments 303 of a reference layer 301 and a free layer 302 composing the tunneling magneto-resistor are perpendicular to each other, the magnetic moment 303 of the reference layer 301 is perpendicular to a film surface, and the magnetic moment 303 of the free layer 302 is parallel to the film surface, so that the magnetic moments 303 of the reference layer 301 and the free layer 302 have an orthogonal anisotropy, and a sensing film surface of the tunneling magneto-resistor is located on the x-y plane shown in FIG. 2. Accordingly, the resistor of tunneling magneto-resistance is capable of producing linear changes shown in FIG. 4 for changes of an externally applied magnetic field in a vertical direction (sensing axis shown in FIG. 3 being a z-direction shown in FIG. 2).

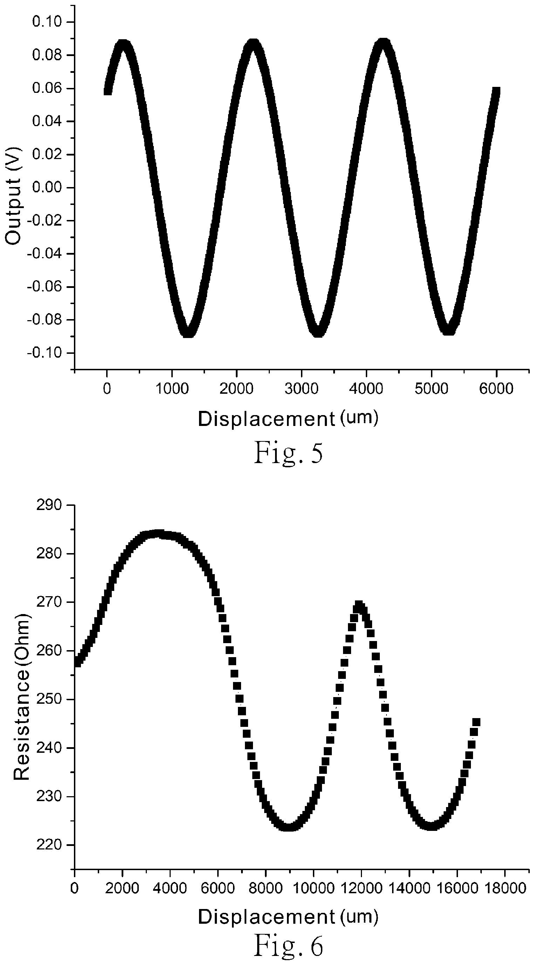

Furthermore, the sensing film surface of the tunneling magneto-resistor of the second magneto-resistive unit 32 located on the x-y plane shown in FIG. 2, can be affected by a sine wave field in the z-direction shown in FIG. 2 generated by the incremental column magnetic track 22 to generate a sensing signal shown in FIG. 5. Furthermore, for the sensing film surface of the tunneling magneto-resistor of the first magneto-resistive unit 31 located on the x-y plane shown in FIG. 2, it is only required to determine positive or negative magnetic field of the absolute column magnetic track 21 in the z-direction shown in FIG. 2. Therefore, under the above-mentioned relative displacement, the free layer 302 in the tunneling magneto-resistor of the first magneto-resistive unit 31 will change direction as the magnetic pole changes, while the reference layer 301 will be maintained in a same direction, resulting in a difference between high and low resistances generating a sensing signal shown in FIG. 6 to determine its magnetic pole polarity.

With the orthogonal anisotropy of the magnetic moments 303 between the reference layer 301 and the free layer 302 of the tunneling magneto-resistors, magnetic field changes of the absolute column magnetic track 21 and the incremental column magnetic track 22 in the magnetic ruler can be sensed with the tunneling magneto-resistors with the same structure to obtain the correct position information.

More importantly, in addition to the first magneto-resistive units 31 and the second magneto-resistive unit 32 having the same structure, positions of the first magneto-resistive units 31 and the second magneto-resistive unit 32 relative to the encoding element 20 are also based on the same plane, that is the x-y plane shown in FIG. 2. In this way, predetermined quantities of the first magneto-resistive units 31 and the second magneto-resistive unit 32 with defined relative positions that are composed of the tunneling magneto-resistor can be formed on a base plate 33 (indicated by a dotted line in FIG. 2) together with the same thin film deposition, photolithography and etching procedures used in the conventional semiconductor manufacturing process. Thus, the drawbacks caused by the need to assemble different discrete sensing elements as in the prior art can be eliminated in order to obtain the position sensing mechanism of the invention that does not require assembly of sensing elements to ensure sensing accuracy.

## Claims

1. A position sensing mechanism comprising:
an encoding element (20) having an absolute column magnetic track (21) and an incremental column magnetic track (22) extending side by side with each other along a virtual moving axis;
a reading element (30) adjacent to and spaced apart from the encoding element (20), and changing in position relative to the encoding element (20) on the moving axis, the reading element (30) having a first magneto-resistive unit (31) acted on by the absolute column magnetic track (21), and a second magneto-resistive unit (32) acted on by the incremental column magnetic track (22); and
a processing unit electrically connected to the reading element (30) for receiving signals generated by the first magneto-resistive unit (31) and the second magneto-resistive unit (32) under actions of the absolute column magnetic track (21) and the incremental column magnetic track (22) respectively, and analyzing positions with the signals received;
the first magneto-resistive unit (31) and the second magneto-resistive unit (32) are tunneling magneto-resistors respectively, each of the first and second magneto-resistive units (31, 32) having a reference layer (301) and a free layer (302), and each reference layer (301) and free layer (302) having a magnetic moment, respectively,
**characterized in that** magnetic moments of the reference layer (301) and the efree layer (302) of the first magneto-resistive unit (31) and the second magneto-resistive unit (32), respectively, are perpendicular to each other, and in the reference layer (301) and the free layer (302), the magnetic moment of one of the layers is parallel to a sensing film surface of the first magneto-resistive unit (31), and the magnetic moment of the other layer is perpendicular to the sensing film surface;
wherein the magnetic moment perpendicular to the sensing film surface is the magnetic moment of the reference layer (301) or the magnetic moment of the free layer (302);
wherein the reading element (30) further comprises a chip, and the first magneto-resistive unit (31) and the second magneto-resistive unit (32) are respectively formed on the chip;
wherein the first magneto-resistive unit (31) has a single magnetic tunneling junction; and
wherein the second magneto-resistive unit (32) is a bridge tunneling magneto-resistor.

## Patentansprüche

1. Eine Positionserfassungsvorrichtung, umfassend:
ein Kodierelement (20), das eine absolute Spaltenmagnetspur (21) und eine inkrementelle Spaltenmagnetspur (22) aufweist, die sich nebeneinanderher entlang einer virtuellen Bewegungsachse erstrecken;
ein Leseelement (30), das zu dem Kodierelement (20) benachbart und davon beabstandet ist und seine Position relativ zum Kodierelement (20) auf der Bewegungsachse ändert, wobei das Leseelement (30) eine erste magnetoresistive Einheit (31), auf welche die absolute Spaltenmagnetspur (21) einwirkt, und eine zweite magnetoresistive Einheit (32) aufweist, auf welche die inkrementelle Spaltenmagnetspur (22) einwirkt; und
eine Verarbeitungseinheit, die elektrisch mit dem Leseelement (30) verbunden ist, um Signale zu empfangen, die von der ersten magnetoresistiven Einheit (31) und der zweiten magnetoresistiven Einheit (32) jeweils unter Aktionen der absoluten Spaltenmagnetspur (21) und der inkrementellen Spaltenmagnetspur (22) erzeugt werden, und zum Analysieren von Positionen anhand der empfangenen Signale;
wobei die erste magnetoresistive Einheit (31) und die zweite magnetoresistive Einheit (32) jeweils Tunnelmagnetwiderstände sind, wobei jede der ersten und zweiten magnetoresistiven Einheiten (31, 32) eine Referenzschicht (301) und eine freie Schicht (302) aufweist, und jede Referenzschicht (301) und freie Schicht (302) jeweils ein magnetisches Moment hat,
**dadurch gekennzeichnet, dass**
die magnetischen Momente der Referenzschicht (301) und der freien Schicht (302) der ersten magnetoresistiven Einheit (31) und der zweiten magnetoresistiven Einheit (32) jeweils senkrecht zueinander sind, und wobei in der Referenzschicht (301) und der freien Schicht (302) das magnetische Moment von einer der Schichten parallel zu einer Sensorfilmoberfläche der ersten magnetoresistiven Einheit (31) ist,
und wobei das magnetische Moment der anderen Schicht senkrecht zur Sensorfilmoberfläche ist;
wobei das magnetische Moment senkrecht zur Sensorfilmoberfläche das magnetische Moment der Referenzschicht (301) oder das magnetische Moment der freien Schicht (302) ist;
wobei das Leseelement (30) ferner einen Chip umfasst, wobei die erste magnetoresistive Einheit (31) und die zweite magnetoresistive Einheit (32) jeweils an dem Chip ausgebildet sind;
wobei die erste magnetoresistive Einheit (31) einen einzelnen magnetischen Tunnelübergang hat; und
wobei die zweite magnetoresistive Einheit (32) ein Brückentunnel-Magnetowiderstand ist.

## Revendications

1. Un mécanisme de détection de position comprenant :
un élément de codage (20) présentant une piste magnétique de colonne absolue (21) et une piste magnétique de colonne incrémentale (22) s'étendant côte à côte l'une par rapport à l'autre le long d'un axe de déplacement virtuel ;
un élément de lecture (30) adjacent par rapport à et espacé de l'élément de codage (20), et changeant de position par rapport à l'élément de codage (20) sur l'axe de déplacement, l'élément de lecture (30) présentant une première unité magnétorésistive (31) sur laquelle agit la piste magnétique de colonne absolue (21), et une seconde unité magnétorésistive (32) sur laquelle agit la piste magnétique de colonne incrémentale (22) ; et
une unité de traitement connectée électriquement à l'élément de lecture (30) destinée à recevoir des signaux générés par la première unité magnétorésistive (31) et la seconde unité magnétorésistive (32) sous les actions de la piste magnétique de colonne absolue (21) et de la piste magnétique de colonne incrémentale (22), respectivement, et analyser les positions avec les signaux reçus ;
la première unité magnétorésistive (31) et la seconde unité magnétorésistive (32) sont respectivement des magnétorésistances à effet tunnel, chacune des première et seconde unités magnétorésistives (31, 32) présentant une couche de référence (301) et une couche libre (302), et chaque couche de référence (301) et chaque couche libre (302) présentant respectivement un moment magnétique,
**caractérisé en ce que**
les moments magnétiques de la couche de référence (301) et de la couche libre (302) de la première unité magnétorésistive (31) et de la seconde unité magnétorésistive (32), respectivement, sont perpendiculaires l'un à l'autre, et dans la couche de référence (301) et la couche libre (302), le moment magnétique de l'une des couches est parallèle à une surface de film de détection de la première unité magnétorésistive (31), et le moment magnétique de l'autre couche est perpendiculaire à la surface de film de détection ;
dans lequel le moment magnétique perpendiculaire à la surface de film de détection est le moment magnétique de la couche de référence (301) ou le moment magnétique de la couche libre (302) ;
dans lequel l'élément de lecture (30) comprend en outre une puce, et la première unité magnétorésistive (31) et la seconde unité magnétorésistive (32) sont respectivement formées sur la puce ;
dans lequel la première unité magnétorésistive (31) présente une seule jonction à effet tunnel magnétique ; et
dans lequel la seconde unité magnétorésistive (32) est une magnéto-résistance à effet tunnel en pont.
